# EUROPÄISCHE PATENTSCHRIFT

(11) **EP 2 726 488 B1**
(45) Veröffentlichungstag und Bekanntmachung des Hinweises auf die Patenterteilung: **07.10.2015**
(21) Anmeldenummer: 12738418.8
(22) Anmeldetag: 29.06.2012
(51) Int. Cl.: C07F 9/50, C07F 1/00, H01L 51/50, C07F 1/08, H01L 51/00

(54) **KUPFER(I)KOMPLEXE, INSBESONDERE FÜR OPTOELEKTRONISCHE BAUELEMENTE**
COPPER(I) COMPLEXES, IN PARTICULAR FOR OPTOELECTRONIC COMPONENTS
COMPLEXES DE CUIVRE(I), EN PARTICULIER POUR COMPOSANTS OPTOÉLECTRONIQUES

(30) Priorität: 29.06.2011 EP 11171921; 08.07.2011 EP 11173369; 26.08.2011 EP 11179099
(43) Veröffentlichungstag der Anmeldung: 07.05.2014
(73) Patentinhaber: cynora GmbH, 76646 Bruchsal (DE)
(72) Erfinder: BAUMANN, Thomas, 76133 Karlsruhe (DE); GRAB, Tobias, 76133 Karlsruhe (DE); ZINK, Daniel, 76646 Bruchsal (DE)
(74) Vertreter: Hoppe, Georg Johannes
(86) Internationale Anmeldenummer: PCT/EP2012/062783
(87) Internationale Veröffentlichungsnummer: WO 2013/001086

(56) Entgegenhaltungen:
- WO-A1-2010/149748
- THIADIAZOLYLPHOSPHINES WITH NITROGEN-CONTAINING SUBSTITUENTS: "Thiadiazolylphosphines with nitrogen-containing substituents", CHEMISTRY OF HETEROCYCLIC COMPOUNDS, SPRINGER NEW YORK LLC, US, Bd. 33, Nr. 10, 1. Oktober 1997 (1997-10-01), Seiten 1242-1243, XP009163062, ISSN: 0009-3122, DOI: 10.1007/BF02290879
- ZARUDNITSKII EVGENIJ V ET AL: "C-phosphorylation of 1,2,4-triazoles with phosphorus(III) halides. Synthesis of 4,5-dihydrobenzo[e][1,2,4]triazolo[5,1- c][1,4,2]diazaphosphinine derivatives", HETEROATOM CHEMISTRY, VCH PUBLISHERS, DERFIELD BEACH, FL, US, Bd. 13, Nr. 2, 1. Januar 2002 (2002-01-01) , Seiten 146-152, XP009163061, ISSN: 1042-7163, DOI: 10.1002/HC.10010 [gefunden am 2002-03-12]
- GUILLERM G ET AL: "Cycloaddition dipolaire 1-3 diazoalcanes sur des composös alcynylés des groupes IVB, VB et VIB = 1,3-Dipolar cycloaddition of diazoalkanes to group IVB, VB, and VIB acetylene derivatives", BULLETIN DE LA SOCIETE CHIMIQUE DE FRANCE, SOCIETE FRANCAISE DE CHIMIE. PARIS, FRANCE, Bd. 9-10, Nr. 2, 1. Januar 1973 (1973-01-01), Seiten 2739-2746, XP009163060, ISSN: 0037-8968
- IGAU ALAIN ET AL: "Analogous .alpha.,.alpha.'-bis-carbenoid, triply bonded species: synthesis of a stable .lambda.3-phosphino carbene-.lambda.5-phosphaacetylene", JOURNAL OF THE AMERICAN CHEMICAL SOCIETY, ACS PUBLICATIONS, US, Bd. 110, Nr. 19, 1. September 1988 (1988-09-01), Seiten 6463-6466, XP009163063, ISSN: 0002-7863, DOI: 10.1021/JA00227A028

## Beschreibung

Die Erfindung betrifft Kupfer(I)komplexe der allgemeinen Formel A, insbesondere zur Verwendung in optoelektronischen Bauelementen. Kupferkomplexe sind bereits aus der WO 2010/169748 A1 bekannt.

### Einleitung

Zur Zeit zeichnet sich ein drastischer Wandel im Bereich der Bildschirm- und Beleuchtungstechnik ab. Es wird möglich sein, flache Displays oder Leuchtflächen mit einer Dicke von unter 0,5 mm zu fertigen. Diese neue Technik basiert auf dem Prinzip der **OLEDs**, den **O**rganic **L**ight Emitting **D**iodes.

Derartige Bauteile bestehen vorwiegend aus organischen Schichten. Bei einer Spannung von z. B. 5 V bis 10 V treten aus einer leitenden Metallschicht, z. B. aus einer Aluminium-Kathode, Elektronen in eine dünne Elektronen-Leitungsschicht und wandern in Richtung der Anode. Diese besteht z. B. aus einer durchsichtigen, aber elektrisch leitenden, dünnen Indium-Zinn-Oxid-Schicht, von der positive Ladungsträger, sog. Löcher, in eine organische Löcher-Leitungsschicht einwandern. Diese Löcher bewegen sich im Vergleich zu den Elektronen in entgegengesetzter Richtung, und zwar auf die Kathode zu. In einer mittleren Schicht, der Emitterschicht, die ebenfalls aus einem organischen Material besteht, befinden sich zusätzlich besondere Emitter-Moleküle, an denen oder in deren Nähe die beiden Ladungsträger rekombinieren und dabei zu neutralen, aber energetisch angeregten Zuständen der Emitter-Moleküle führen. Die angeregten Zustände geben dann ihre Energie als helle Lichtemission ab, z. B. in blauer, grüner oder roter Farbe. Auch Weiß-Licht-Emission ist realisierbar. Auf die Emitterschicht kann gegebenenfalls auch verzichtet werden, wenn die Emittermoleküle sich in der Loch- oder Elektronen-Leitungsschicht befinden.

Entscheidend für den Bau effektiver OLEDs sind die verwendeten Leuchtmaterialien (Emitter-Moleküle). Diese können in verschiedener Weise realisiert werden, und zwar unter Verwendung rein organischer oder metall-organischer Moleküle sowie von Komplexverbindungen. Es lässt sich zeigen, dass die Lichtausbeute der OLEDs mit metall-organischen Substanzen, den sog. Triplett-Emittern, wesentlich größer sein kann als für rein organische Materialien. Aufgrund dieser Eigenschaft kommt der Weiterentwicklung der metall-organischen Materialien ein wesentlicher Stellenwert zu. Unter Einsatz von metallorganischen Komplexen mit hoher Emissionsquantenausbeute (Übergänge unter Einbeziehung der untersten Triplett-Zustände zu den Singulett-Grundzuständen) lässt sich eine besonders hohe Effizienz des Devices erzielen. Diese Materialien werden häufig als Triplett-Emitter oder phosphoreszierende Emitter bezeichnet.

Vor diesem Hintergrund lag der vorliegenden Erfindung die Aufgabe zu Grunde, neue Verbindungen bereitzustellen, die für optoelektronische Bauelemente geeignet sind.

### Beschreibung der Erfindung

Das der Erfindung zu Grunde liegende Problem wird durch die Bereitstellung von Kupfer(I)komplexen der Form Cu₂X*₂(E∩N*)₃ gelöst, die eine Struktur gemäß Formel A aufweisen: 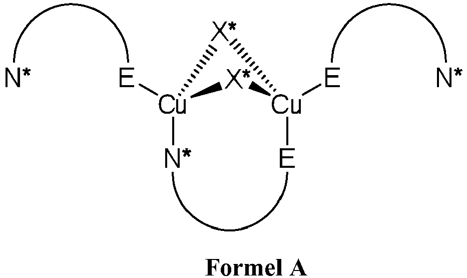 mit:
X* = Cl, Br, I, CN, SCN, Alkinyl und/oder N₃ (also unabhängig voneinander, so dass der Komplex zwei gleiche oder zwei unterschiedliche Atome X* aufweisen kann);
E = R₂ As und/oder R₂P;
N*∩E = zweibindige Liganden mit E = Phosphanyl/Arsenyl-Rest der Form R₂E (R = Alkyl, Aryl, Alkoxyl, Phenoxyl, Amid); N* = Imin-Funktion. Bei "∩" handelt es sich um ein Kohlenstoffatom. Insbesondere handelt es sich bei E um eine Ph₂P-Gruppe (Ph = Phenyl), die Imin-Funktion ist Bestandteil eines N-heteroaromatischen 5-Rings wie Pyrazol, Isoxazol, Isothiazol, Triazol, Oxadiazol, Thiadiazol, Tetrazol, Oxatriazol oder Thiatriazol. "∩" ist ebenfalls Bestandteil dieser aromatischen Gruppe. Das Kohlenstoffatom befindet sich sowohl direkt benachbart zum Imin-Stickstoff-Atom als auch zum E-Atom. N*∩E kann optional substituiert sein, insbesondere mit mindestens einer Gruppe, die die Löslichkeit des Kupfer(I)komplexes in den gängigen organischen Lösungsmitteln zur OLED-Bauteilherstellung erhöht. Gängige organische Lösungsmittel umfassen, neben Alkoholen, Ethern, Alkanen sowie halogenierten aliphatischen und aromatischen Kohlenwasserstoffen und alkylierten aromatischen Kohlenwasserstoffen, insbesondere Toluol, Chlorbenzol, Dichlorbenzol, Mesitylen, Xylol, Tetrahydrofuran, Phenetol, Propiophenon.

Ein erfindungsgemäßer Kupfer(I)komplex besteht in einer bevorzugten Ausführungsform aus drei identischen Liganden N*∩E, die direkt als Ladungstransportmolekül fungieren können, wodurch unterschiedliche Funktionalitäten direkt über die jeweiligen Liganden eingeführt werden können (beispielsweise eine Lochtransport- oder Elektrontransport-Einheit, im Folgenden als Loch- bzw. Elektronenleiter bezeichnet) und somit ein optimaler Ladungsträgertransport zu und auf dem Kupferkomplex gewährleistet wird, ohne dass diese Funktionalitäten über zusätzlichen Einheiten an der Peripherie der jeweiligen Liganden angebracht werden müssen, was den Syntheseaufwand und damit die Kosten der Herstellung vermindert. Aus dem gleichen Grund weist der erfindungsgemäße Kupfer(I)komplex auch bevorzugt identische Atome X* auf. Der große Vorteil bei der Verwendung von Kupfer als Zentralmetall ist dessen niedriger Preis, vor allem im Vergleich zu den sonst bei OLED-Emittern üblichen Metallen wie Re, Os, Ir und Pt. Zusätzlich spricht auch die geringe Toxizität des Kupfers für dessen Verwendung.

Hinsichtlich ihrer Verwendung in optoelektronischen Bauelementen zeichnen sich die erfindungsgemäßen Kupfer(I)komplexe durch einen weiten Bereich von erzielbaren Emissionsfarben aus. Zudem ist die Emissionsquantenausbeute hoch, insbesondere größer als 50 %. Für Emitterkomplexe mit Cu-Zentralion, sind die Emissionsabklingzeiten erstaunlich kurz.

Außerdem sind die erfindungsgemäßen Kupfer(I)komplexe in relativ hohen Emitterkonzentrationen ohne deutliche Quencheffekte verwendbar. Das heißt, im Emitter-Layer können Emitterkonzentrationen von 5 % bis 100 % verwendet werden.

Bevorzugt handelt es sich bei dem Liganden N*∩E um Pyrazole, Isoxazole, Isothiazole, 1,2,4-Triazole, 1,2,4-Oxadiazole, 1,2,4-Thiadiazole, Tetrazole, 1,2,3,4-Oxatriazole und/oder 1,2,3,4-Thiatriazole, die jeweils substituiert sein können, wie hierin beschrieben. Diese Liganden können direkt als Ladungstransportmoleküle fungieren, wodurch unterschiedliche Funktionalitäten direkt über die jeweiligen Liganden eingeführt werden können (beispielsweise eine Lochtransport- oder Elektrontransport-Einheit, im Folgenden als Loch- bzw. Elektronenleiter bezeichnet) und somit ein optimaler Ladungsträgertransport zu und auf dem Kupferkomplex gewährleistet wird, ohne dass diese Funktionalitäten über zusätzlichen Einheiten an der Peripherie der jeweiligen Liganden angebracht werden müssen,

Besonders bevorzugt handelt es sich bei dem Liganden N*∩E um folgende Liganden:

| | |
|---|---|
| 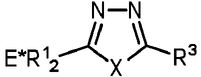 | X = NR²: 3E*R¹₂-4R²-5R³-4*H*-1,2,4-Triazol |
| | X = O: 2E*R¹₂-5R³-1,3,4-Oxadiazol |
| | X = S: 2PR¹₂-5R³-1,3,4-Thiadiazol |
| | |
| 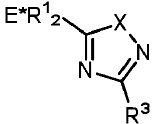 | X = NR²: 1R²-3R³-5E*R¹₂-1*H*-1,2,4-Triazol |
| | X = O: 3R³-5E*R¹₂-1,2,4-Oxadiazol |
| | X = S: 3R³-5E*R¹₂-1,2,4-Thiadiazol |
| | |
| 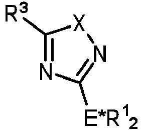 | X = NR²: 1R²-3E*R¹₂-5R³-1*H-*1,2,4-Triazol |
| | X = O: 3E*R¹₂-5R³-1,2,4-Oxadiazol |
| | X = S: 3ER¹₂-5R³-1,2,4-Thiadiazol |
| | |
| 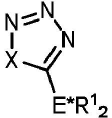 | X = NR²: 1 R²-5E*R¹₂-1*H*-Tetrazol |
| | X = O: 5E*R¹₂-1,2,3,4-Oxatriazol |
| | X = S: 5E*R¹₂-1,2,3,4-Thiatriazol |
| 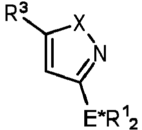 | X = NR²: 1 R²-3E*R¹₂-5R³-1*H*-Pyrazol |
| | X = O: 3E*R¹₂-5R³-Isoxazol |
| | X = S: 3E*R¹₂-5R³-Isothiazol |

mit
X = O, S oder NR²;
E* = As oder P;
R1-R3 können jeweils unabhängig voneinander Wasserstoff, Halogen sein oder Substituenten, die über Sauerstoff- (-OR), Stickstoff- (-NR₂) oder Siliziumatome (-SiR₃) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen. R2-R3 können optional auch zu annelierten Ringsystemen führen.

Die Erfindung betrifft auch ein Verfahren zur Herstellung eines erfindungsgemäßen Kupfer(I)komplexes. Dieses erfindungsgemäße Verfahren weist den Schritt des Durchführens einer Reaktion von N*∩E mit Cu(I)X* auf,
wobei
X* = Cl, Br, I, CN, SCN, Alkinyl und/oder N₃ (unabhängig voneinander);
N*∩E = ein zweibindiger Ligand mit
E = Phosphanyl/Arsenyl-Rest der Form R₂E (mit R = Alkyl, Aryl, Alkoxyl, Phenoxyl, oder Amid);
N* = Imin-Funktion, die Bestandteil eines N-heteroaromatischen 5-Rings, wie Pyrazole, Isoxazole, Isothiazole, Triazol, Oxadiazol, Thiadiazol, Tetrazol, Oxatriazol oder Thiatriazol ist,
"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor- oder Arsenatom befindet.
Der optional am Liganden N*∩E vorhandene mindestens eine Substituent zur Erhöhung der Löslichkeit des Komplexes in organischen Lösungsmitteln ist weiter unten beschrieben.

Die Reaktion wird bevorzugter Weise in Dichlormethan (DCM) durchgeführt, wobei auch andere organische Lösungsmittel wie Acetonitril oder Tetrahydrofuran oder Dimethylsulfoxid oder Ethanol verwendet werden können. Durch die Zugabe von Diethylether oder Hexan oder Methyl-tert-butylether oder Pentan oder Methanol oder Ethanol oder Wasser zum gelösten Produkt kann ein Feststoff gewonnen werden. Letzteres kann durch Fällung oder Eindiffusion oder in einem Ultraschall-Bad durchgeführt werden.

Bei der Reaktion von zweizähnigen P∩N*-Liganden (P∩N* = Phosphan-Ligand, Definition s. u.) mit Cu(I)X* (X* = Cl, Br, I, CN, SCN, Alkinyl und/oder N₃), bevorzugt in Dichlormethan (DCM), bevorzugt bei Raumtemperatur, entsteht der zweikernige 2:3-Komplex Cu₂X*₂(P∩N*)₃, in dem die Cu-Atome durch einen Phosphanligand sowie die beiden Halogenid-Anionen überbrückt werden (Gl. 1). Die anderen beiden P∩N*-Liganden koordinieren jeweils nur mit ihren Phosphoratomen an jeweils ein Cu-Atom, und vervollständigen somit die Koordinationszahl der butterfly-förmigen Cu₂X*₂-Struktur.

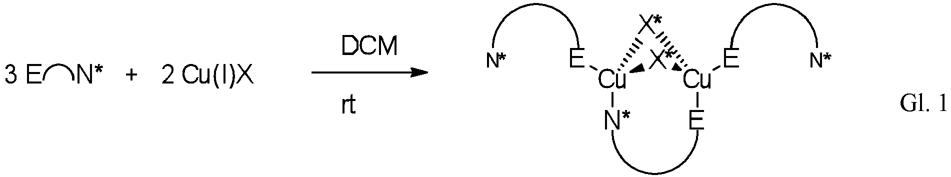

Die Struktur der Formel A ist verwandt mit bekannten Komplexen der Form Cu₂X*₂L₂L' bzw. Cu₂X*₂L₄. Anders als bei Cu₂X*₂L₂L' ist der Komplex jedoch in nur einem Schritt durch Umsetzung von Cu(I)X* mit dem zweizähnigen P∩N* Liganden zugänglich. Der Komplex kann durch Fällen mit Et₂O als gelbes oder rotes mikrokristallines Pulver isoliert werden. Einkristalle können durch langsames Eindiffundieren von Et₂O in die Reaktionslösung erhalten werden. Die Identitäten der Komplexe wurden eindeutig durch Elementar- und Röntgenstrukturanalysen belegt.

Hierbei handelt es sich um die oben aufgeführte allgemeine Formel A. Die zweizähnigen E∩N*-Liganden können unabhängig voneinander mindestens einen Substituenten umfassen: Die Substituenten können jeweils unabhängig voneinander Wasserstoff, Halogen sein oder Substituenten, die über Sauerstoff- (-OR), Stickstoff- (-NR₂) oder Siliziumatome (-SiR₃) gebunden sind sowie Alkyl- (auch verzweigt oder zyklisch), Aryl-, Heteroaryl-, Alkenyl-, Alkinyl-Gruppen bzw. substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere allgemein bekannte Donor- und Akzeptor-Gruppen, wie beispielsweise Amine, Carboxylate und deren Ester, und CF₃-Gruppen. Die Substituenten können optional auch zu annelierten Ringsystemen führen.

### Löslichkeit

Bei der Herstellung von opto-elektronischen Bauteilen mittels nass-chemischer Prozesse ist es vorteilhaft, die Löslichkeit gezielt einzustellen. Hierdurch kann das Auf- bzw. Anlösen einer bereits aufgebrachten Schicht vermieden werden. Durch das Einbringen spezieller Substituenten können die Löslichkeitseigenschaften stark beeinflusst werden. Dadurch ist es möglich, orthogonale Lösungsmittel zu verwenden, die jeweils nur die Substanzen des aktuellen Verarbeitungsschrittes lösen, aber nicht die Substanzen der darunter liegenden Schicht(en). Zu diesem Zweck können die Substituenten R2-R3 so gewählt werden, dass sie eine Abstimmung der Löslichkeiten erlauben. Folgende Möglichkeiten zur Auswahl entsprechender Substituenten sind gegeben:

### Löslichkeit in unpolaren Medien

Unpolare Substitutenten R2-R3 erhöhen die Löslichkeit in unpolaren Lösungsmitteln und erniedrigen die Löslichkeit in polaren Lösungsmitteln. Unpolare Gruppen sind z. B. Alkylgruppen [CH₃-(CH₂)ₙ-] (n = 1 - 30), auch verzweigte oder zyklische, substituierte Alkylgruppen, z. B. mit Halogenen. Hierbei sind besonders hervorzuheben: teil- oder perfluorierte Alkylgruppen sowie perfluorierte Oligo- und Polyether, z. B. [-(CF₂)₂-O]ₙ - und (-CF₂-O)ₙ- (n = 2 - 500). Weitere unpolare Gruppen sind: Ether -OR*, Thioether -SR*, unterschiedlich substituierte Silane R*₃Si- (R* = Alkyl oder Aryl), Siloxane R*₃Si-O-, Oligosiloxane R**(-R₂Si-O)ₙ- (R** = R*, n = 2 - 20), Polysiloxane R**(-R*₂Si-O)ₙ- (n > 20); Oligo/polyphosphazene R**(-R*₂P=N-)ₙ- (n = 1 - 200).

### Löslichkeit in polaren Medien

Polare Substitutenten R2-R3 erhöhen die Löslichkeit in polaren Lösungsmitteln. Diese können sein:
- Alkohol-Gruppen: -OH
- Carbonsäure-, Phosphonsäure-, Sulfonsäure-Reste sowie deren Salze und Ester (R* = H, Alkyl, Aryl, Halogen; Kationen: Alkalimetalle, Ammonium-Salze):
   -COOH, -P(O)(OH)₂ , -P(S)(OH)₂ , -S(O)(OH)₂ , -COOR*, -P(O)(OR*)₂, -P(S)(OR*)₂ ,-S(O)(OR*)₂, -CONHR*, -P(O)(NR*₂)₂, -P(S)(NR*₂)₂, -S(O)(NR*₂)₂
- Sulfoxide: -S(O)R*, -S(O)₂R*
- Carbonylgruppen: -C(O)R*
- Amine: -NH₂, -NR*₂, -N(CH₂CH₂OH)₂,
- Hydroxylamine =NOR*
- Oligoester, -O(CH₂O-)ₙ, -O(CH₂CH₂O-)ₙ (n = 2 - 200)
- Positiv geladene Substituenten: z. B. Ammonium-Salze -NR*₃X⁻, Phosphonium-Salze - P⁺R*3X⁻
- Negativ geladene Substituenten, z. B. Borate -(BR*₃)⁻, Aluminate -(AlR*₃)⁻ (als Anion kann ein Alkalimetal oder Ammoniumion fungieren).

Um die Löslichkeit der erfindungsgemäßen Kupfer(I)komplexe in organischen Lösungsmitteln zu verbessern, ist optional mindestens eine der Strukturen N*∩E in bevorzugter Weise mit mindestens einem Substituenten substituiert. Der Substituent kann ausgewählt sein aus der Gruppe bestehend aus:
- langkettigen, verzweigten oder unverzweigten oder zyklischen Alkylketten mit einer Länge von C1 bis C30, bevorzugt mit einer Länge von C3 bis C20, besonders bevorzugt mit einer Länge von C5 bis C15,
- langkettigen, verzweigten oder unverzweigten oder zyklischen, Alkoxyketten einer Länge von C1 bis C30, bevorzugt mit einer Länge von C3 bis C20, besonders bevorzugt mit einer Länge von C5 bis C15,
- verzweigten oder unverzweigten oder zyklischen Perfluoralkylketten einer Länge von C1 bis C30, bevorzugt mit einer Länge von C3 bis C20, besonders bevorzugt mit einer Länge von C5 bis C15 und
- kurzkettigen Polyethern, wie z. B. Polymere der Form (-OCH₂CH₂O-)ₙ, mit n < 500. Beispiele hierfür sind Polyethylenglykole (PEG), die als chemisch inerte, wasserlösliche und nicht-toxische Polymere mit einer Kettenlänge von 3-50 Wiederholungseinheiten eingesetzt werden können.

Die Alkylketten oder Alkoxylketten oder Perfluoralkylketten sind in einer bevorzugten Ausführungsform der Erfindung mit polaren Gruppen modifiziert, z. B. mit Alkoholen, Aldehyden, Acetale, Aminen, Amidine, Carbonsäuren, Carbonsäureestern, Carbonsäureamide, Imide, Carbonsäurehalogenide, Carbonsäureanhydride, Ethern, Halogenen, Hydroxamsäuren, Hydrazine, Hydrazone, Hydroxylamine, Laktone, Laktame, Nitrilen, Isocyanide, Isocyanate, Isothiocyanate, Oxime, Nitrosoaryle, Nitroalkyle, Nitroaryle, Phenole, Phosphorsäureestern und/oder Phosphonsäuren, Thiolen, Thioethern, Thioaldehyde, Thioketone, Thioacetale, Thiocarbonsäuren, Thioester, Dithiosäure, Dithiosäureester, Sulfoxide, Sulfone, Sulfonsäure, Sulfonsäureester, Sulfinsäure, Sulfinsäureester, Sulfensäure, Sulfensäureester, Thiosulfinsäure, Thiosulfinsäureester, Thiosulfonsäure, Thiosulfonsäureester, Sulfonamide, Thiosulfonamide, Sulfinamide, Sulfenamide, Sulfate, Thiosulfate, Sultone, Sultame, Trialkylsilyl- und Triarylsilyl-Gruppen sowie Trialkoxysilyl-Gruppen, die eine weitere Erhöhung der Löslichkeit zur Folge haben.

Eine sehr ausgeprägte Erhöhung der Löslichkeit wird ab mindestens einer C3-Einheit, verzweigt oder unverzweigt oder zyklisch, erreicht. Die Substitution z. B. mit einer linearen C3-Kette (siehe unten) führt zu einer sehr guten Löslichkeit in z. B. Dichlorbenzol und zur guten Löslichkeit in Chlorbenzol und Toluol.

Optional kann das Darstellungsverfahren den Schritt umfassen, dass mindestens ein Ligand N*∩E mit mindestens einem Substituenten zur Erhöhung der Löslichkeit in dem gewünschten organischen Lösungsmittel substituiert wird, wobei der Substituent in einer Ausführungsform der Erfindung ausgewählt sein kann aus o.g. Gruppen.

Erfindungsgemäß sind auch Kupfer(I)komplexe, die durch ein derartiges Syntheseverfahren herstellbar sind.

Die Kupfer(I)komplexe der Formel A können erfindungsgemäß als Emitter in einer Emitterschicht eines Licht-emittierenden optoelektronischen Bauelements eingesetzt werden. Die optoelektronischen Bauelemente sind bevorzugt die folgenden: Organischen Licht-emittierenden Bauteilen (OLEDs), Licht-emittierenden elektrochemischen Zellen, OLED-Sensoren (insbesondere in nicht hermetisch nach außen abgeschirmten Gas- und Dampf-Sensoren), organischen Solarzellen, Organische Feldeffekttransistoren, organische Laser und Down-Konversions-Elemente.

Die Kupfer(I)komplexe der Formel A können erfindungsgemäß auch als Absorber-Materialien in einer Absorberschicht eines optoelektronischen Bauelements eingesetzt werden.

Unter der Bezeichnung "optoelektronische Bauelemente" werden insbesondere verstanden:
- Organische Licht-emittierende Bauteile (organic light emitting diodes, OLEDs)
- Licht-emittierende elektrochemische Zellen (light emitting electrochemical cells, LECs, LEECs),
- OLED-Sensoren, insbesondere in nicht hermetisch nach außen abgeschirmten Gas- und Dampf-Sensoren,
- organische Solarzellen (organic solar cells, OSCs, organic photovoltaics, OPVs),
- Organische Feldeffekttransistoren und
- Organische Laser.

Der Anteil des Kupfer(I)komplexes in der Emitter- oder Absorber-Schicht in einem derartigen optoelektronischen Bauelement beträgt in einer Ausführungsform der Erfindung 100 %. In einer alternativen Ausführungsform beträgt der Anteil des Kupfer(I)komplexes in der Emitter- oder Absorber-Schicht 1 % bis 99 %.

Vorteilhafter Weise beträgt die Konzentration des Kupfer(I)komplexes als Emitter in optischen Licht emittierenden Bauelementen, insbesondere in OLEDs, zwischen 1 % und 99 %, bevorzugt zwischen 1 % und 80 %.

Gegenstand der vorliegenden Erfindung sind auch optoelektronische Bauelemente, die einen hier beschriebenen Kupfer(I)komplex aufweisen. Dabei kann das optoelektronische Bauelement ausgeformt sein als ein organisch lichtemittierendes Bauelement, eine organische Diode, eine organische Solarzelle, ein organischer Transistor, als eine organische Licht-emittierende Diode, eine Licht-emittierende elektrochemische Zelle, ein organischer Feldeffekttransistor und als ein organischer Laser.

Bei einem Verfahren zur Herstellung eines optoelektronischen Bauelements, bei dem ein erfindungsgemäßer Kupfer(I)komplex verwendet wird, kann das Aufbringen eines derartigen Kupfer(I)komplexes auf ein Trägermaterial erfolgen. Dieses Aufbringen kann nass-chemisch, mittels kolloidaler Suspension oder mittels Sublimation erfolgen, insbesondere nass-chemisch. Das Verfahren kann die folgenden Schritte aufweisen:
Aufbringung eines in einem ersten Lösungsmittel gelösten ersten Emitterkomplexes auf einen Träger, und Aufbringung eines in einem zweiten Lösungsmittel gelösten zweiten Emitterkomplexes auf den Träger;
wobei der erste Emitterkomplexes nicht in dem zweiten Lösungsmittel löslich ist und der zweite Emitterkomplexes nicht in dem ersten Lösungsmittel löslich ist; und wobei der erste Emitterkomplex und/oder der zweite Emitterkomplex ein erfindungsgemäßer Kupfer(I)komplex ist. Das Verfahren kann weiterhin den folgenden Schritt aufweisen: Aufbringung eines in dem ersten Lösungsmittel oder in einem dritten Lösungsmittel gelösten dritten Emitterkomplexes auf den Träger, wobei der dritte Kupfer(I)komplex ein erfindungsgemäßer Kupfer(I)komplex ist. Erstes und zweites Lösungsmittel sind dabei nicht identisch.

Ein weiterer Aspekt der Erfindung betrifft ein Verfahren zur Veränderung der Emissions- und/oder Absorptionseigenschaften eines elektronischen Bauelements. Dabei wird ein erfindungsgemäßer Kupfer(I)komplexe in ein Matrixmaterial zur Leitung von Elektronen oder Löchern in ein optoelektronisches Bauelement eingebracht.

Ein weiterer Aspekt der Erfindung betrifft eine Verwendung eines erfindungsgemäßen Kupfer(I)komplexes, insbesondere in einem optoelektronischen Bauelement, zur Umwandlung von UV-Strahlung oder von blauem Licht in sichtbares Licht, insbesondere in grünes, gelbes oder rotes Licht (Down-Konversion).

Die Erfindung betrifft in einem weiteren Aspekt einen zweizähniger Liganden der Formel B zur Herstellung eines Kupferkomplexes der Formel A, sowie das Verfahren zur Herstellung eines derartigen Liganden.

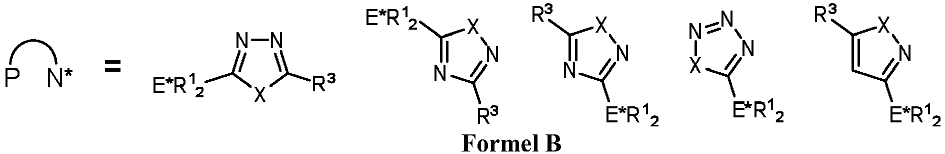

Die in Formel B verwendeten Symbole entsprechen den für Formel A verwendeten Symbolen, die hierin beschrieben sind.

Das Verfahren zur Herstellung eines zweizähnigen Liganden der Formel B wird gemäß dem nachfolgend dargestellten Schema durchgeführt:

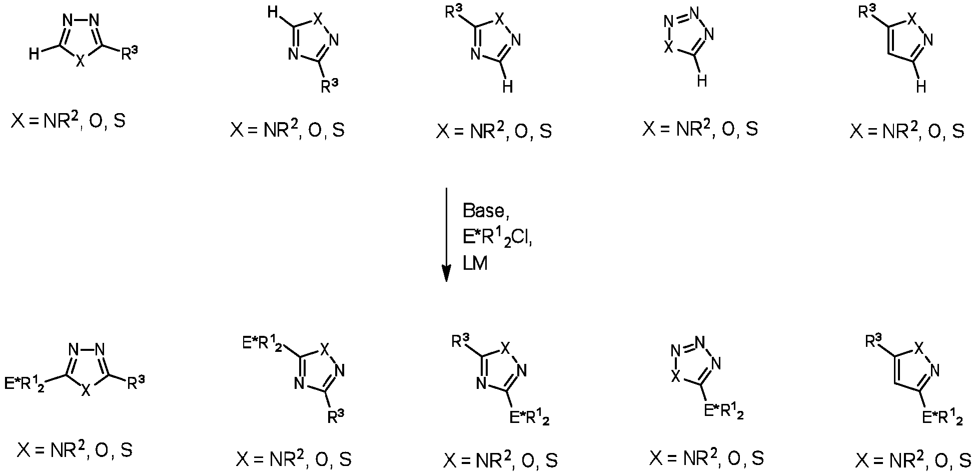

### Beispiele:

In den hier gezeigten Beispielen ist der Ligand E∩N* der allgemeinen Formel A ein Ligand P∩N* (mit E = Ph₂P).

Für die Herstellung der Kupferkomplexe wurden die zweizähnigen Phosphanliganden Pyrazol, Isoxazol, Isothiazol, Triazol, Oxadiazol, Thiadiazol, Tetrazol, Oxatriazol, Thiatriazol entsprechend der obigen Beschreibung verwendet:

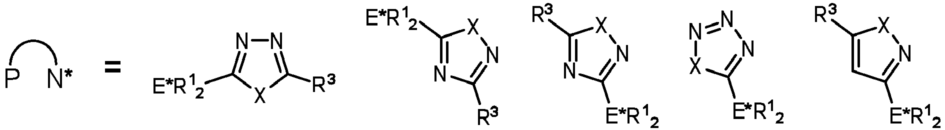

Die Liganden wurden im Falle der Pyrazole, Triazole, Oxadiazole, Thiadiazole, Tetrazole teilweise gemäß Literaturvorschriften hergestellt, während die Isoxazole, Isothiazole, Oxatriazole und Thiatriazole bisher nicht literaturbekannt sind und somit nach einer neuen Synthese dargestellt wurden, die im Folgenden dargestellt ist:

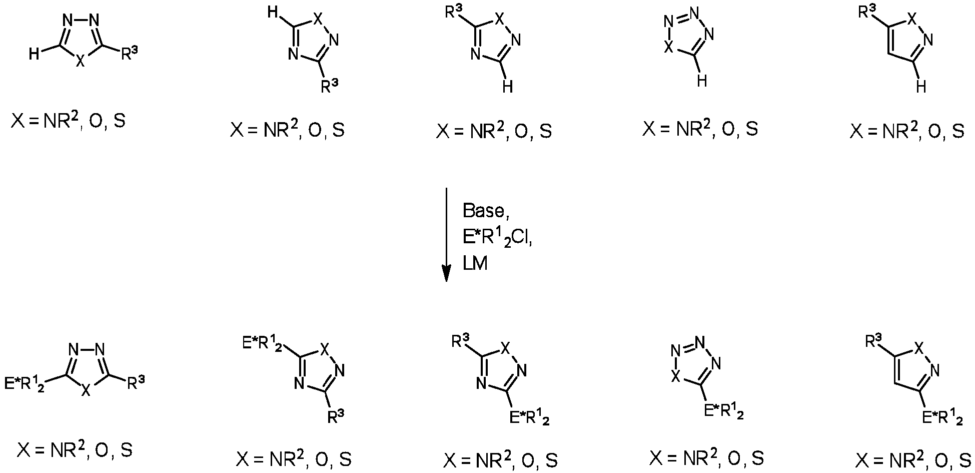

Die im obigen Schema verwendeten Symbolen entsprechen den für Formel A und den Liganden E∩N* verwendeten Symbolen, die oben beschrieben sind.

Die Identitäten der Liganden wurden eindeutig durch NMR-Spektroskopie und Massenspektrometrie belegt.

### Beispiele für Komplexe der Form Cu₂X*₂(P∩N*)₃

### I. P∩N* = Ph₂Ptriaz, 1a-k: Cu₂I₂(Ph₂Ptriaz)₃, 2a-k

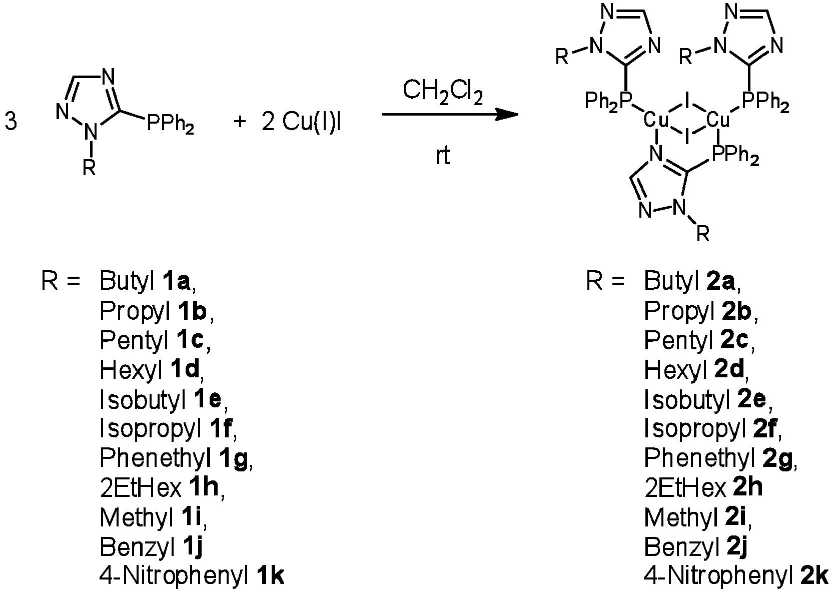

Bei den Verbindungen **2a-j** handelt es sich um weiße, feinkristalline Feststoffe, bei Verbindung **2k** handelt es sich um einen orangefarbenen Feststoff.

### Charakterisierung: Elementaranalyse:

| | |
|---|---|
| **2a** (R = Butyl) | ber.: C 49.55; H 4.62; N 9.63 |
| | gef.: C 49.45; H 4.62; N 9.41 |
| **2b** (R = Propyl) | ber.: C 48.35; H 4.30; N 9.95 |
| | gef.: C 48.10; H 4.27; N 10.06 |
| **2c** (R = Pentyl) | ber.: C 50.67; H 4.92; N 9.33 |
| | gef.: C 50.52; H 4.86; N 9.16 |
| **2d** (R = Hexyl) | ber.: C 51.73; H 5.21; N 9.05 |
| | gef.: C 51.47; H 5.09; N 8.80 |
| **2e** (R = Isobutyl) | ber.: C 49.55; H 4.62; N 9.63 |
| | gef.: C 49.16; H 4.50; N 9.38 |
| **2f** (R = Isopropyl) | ber.: C 48.35; H 4.30; N 9.95 |
| | gef.: C 47.30; H 4.28; N 9.71 |
| **2g** (R = Phenethyl) | ber.: C 56.26; H 4.72; N 8.20 (x1 Cyclohexan) |
| | gef.: C 56.13; H 4.89; N 8.02 |
| **2h** (R = 2EtHex) | ber.: C 52.56; H 5.64; N 8.29 (x0.5 CH₂Cl₂) |
| | gef.: C 52.68; H 5.60; N 8.32 |
| **2i** (R = Methyl) | ber.: C 41.74; H 3.43; N 9.32 (x2 CH₂Cl₂) |
| | gef.: C 42.00; H 3.73; N 8.93 |
| **2j** (R = Benzyl) | ber.: C 53.63, H 3.86; N 8.93 |
| | gef.: C 53.25; H 3.81; N 8.73 |
| **2k** (R = 4-Nitrophenyl) | ber.: C 46.11, H 2.98; N 10.58 |
| | gef.: C 46.30; H 2.99; N 10.50 |

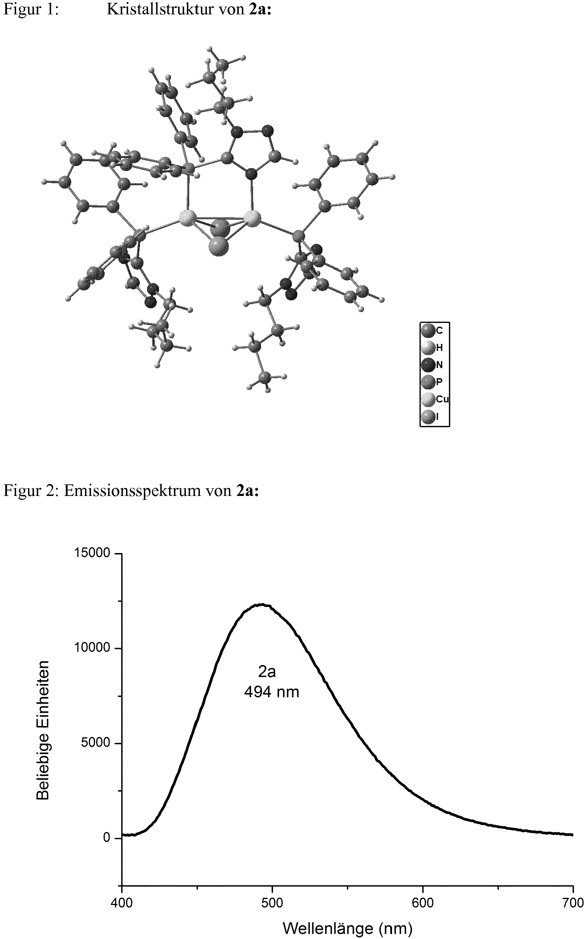

Die Kristallstruktur von **2a** ist in Fig. 1 dargestellt.

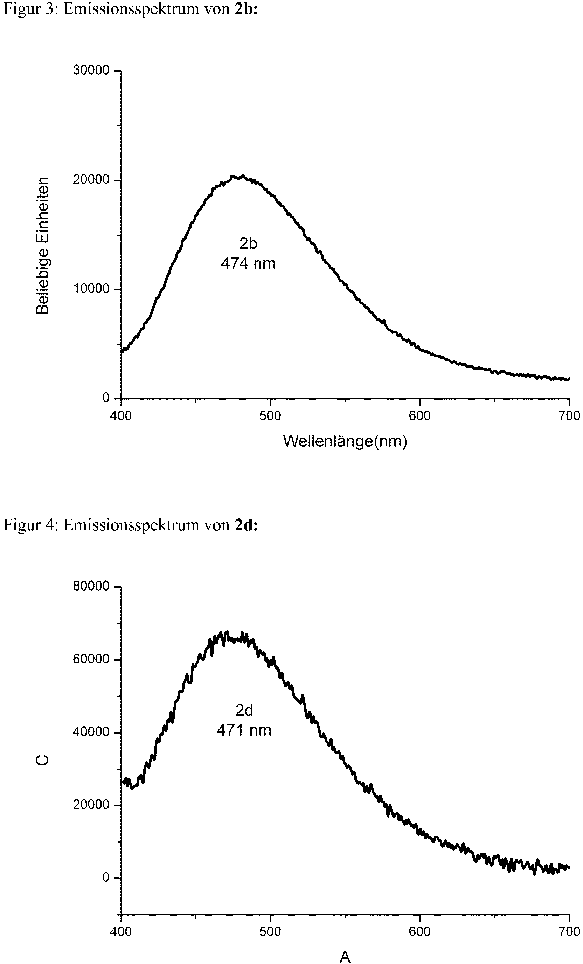

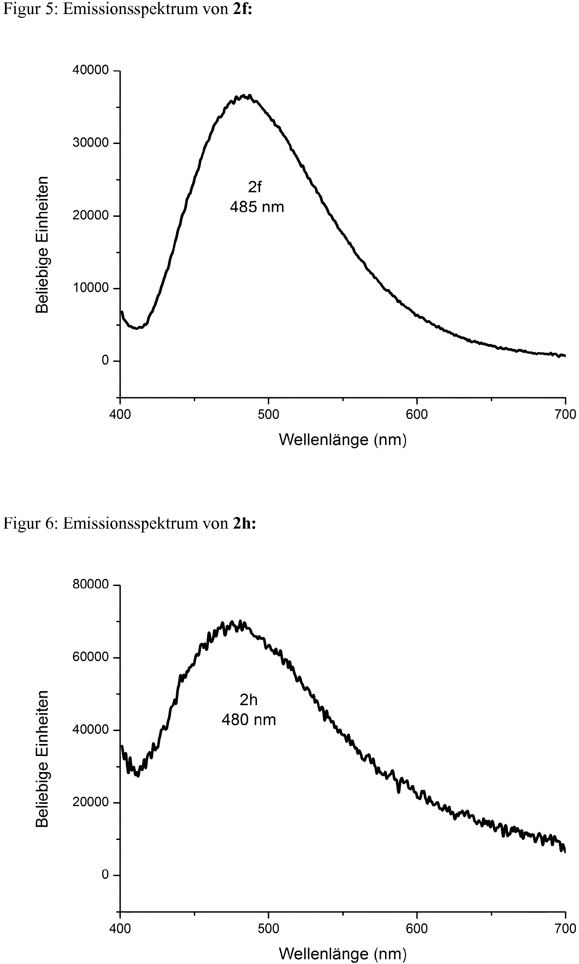

Die Emissionsspektren von **2a, 2b, 2d, 2f, 2h, 2j** sind in Fig. 2-7 gezeigt.

Die Photolumineszenz (PL)-Quantenausbeute von **2a** beträgt 80 % (gemessen mit Hamamatsu C9920-02G).

### II. P∩N* = Ph₂Poxadiaz, 3a-b: Cu₂I₂(Ph₂Poxadiaz)₃, 4a-b

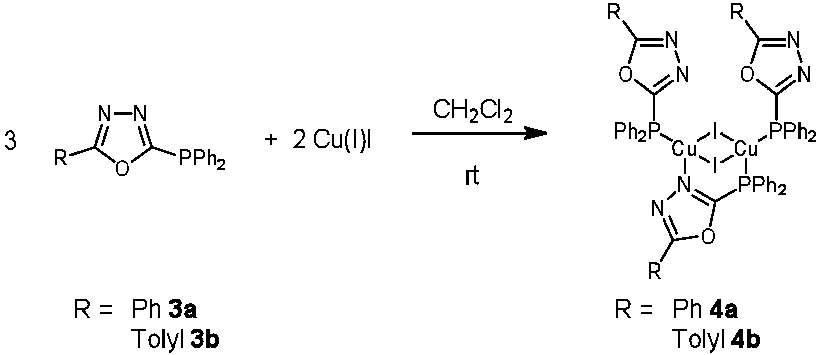

Bei der Verbindung **4a** und **4b** handelt es sich um gelbe, feinkristalline Feststoffe.

### Charakterisierung: Elementaranalyse:

| | |
|---|---|
| **4a** (R = Ph) | ber.: C 52.53; H 3.31; N 6.13 |
| | gef.: C 52.64; H 3.68; N 5.73 |
| **4b (R = Tolyl)** | ber.: C 53.53; H 3.64; N 5.94 |
| | gef.: C 53.90; H 3.68; N 5.86 |

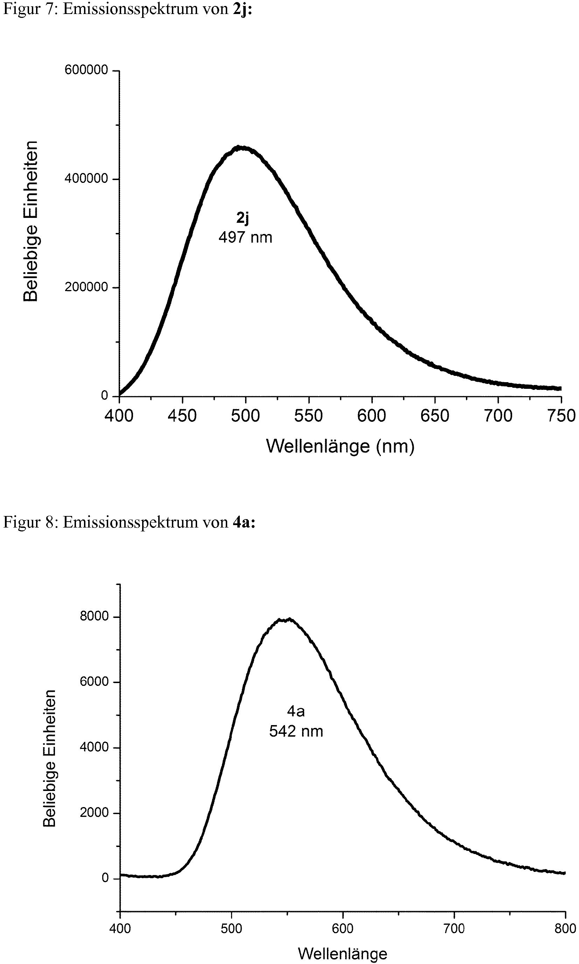

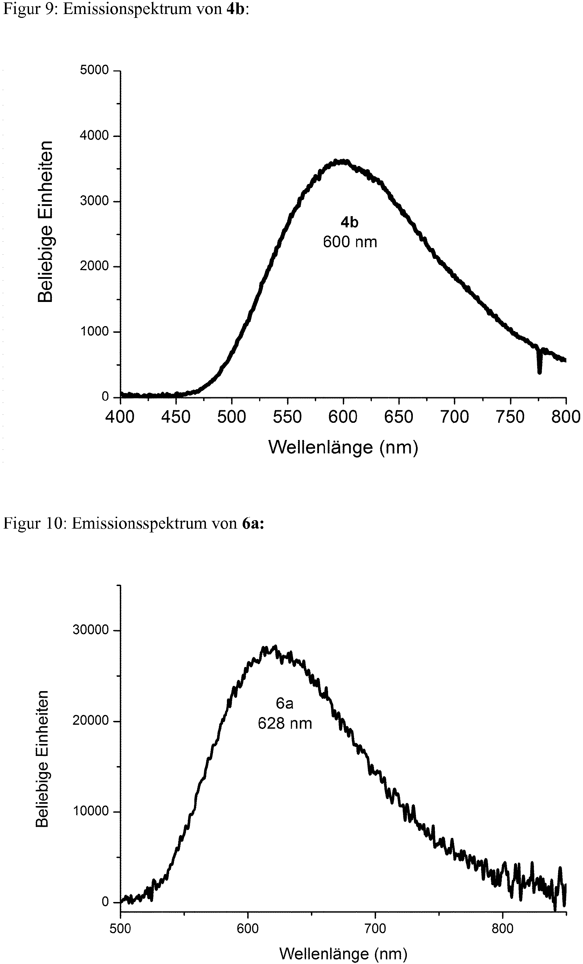

Die Emissionsspektren von **4a** und **4b** sind in Fig. 8 und 9 gezeigt.

Die PL-Quantenausbeute von **4a** beträgt 63%, von **4b** beträgt sie 65% (gemessen mit Hamamatsu C9920-02G).

### III. P∩N* = Ph₂Pthiadiaz, 5a: Cu₂I₂(Ph₂Pthiadiaz)₃, 6a

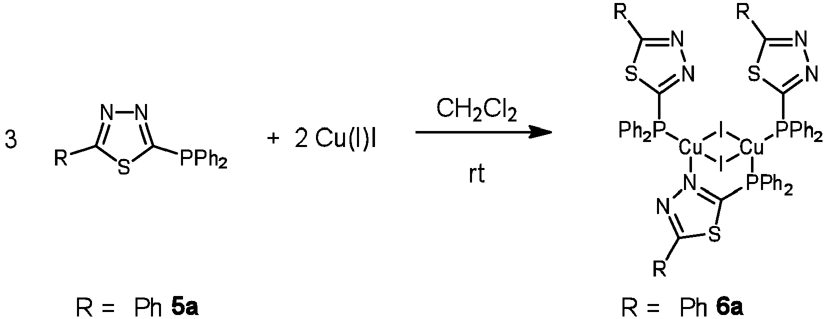

Bei der Verbindung **6a** handelt es sich um einen gelben, feinkristallinen Feststoff.

### Charakterisierung: Elementaranalyse:

| | |
|---|---|
| **6a** (R = Ph) | ber.: C 45.18; H 3.07; N 5.02; S 5.74 (x3 CH₂Cl₂) |
| | gef.: C 45.58; H 3.00; N 5.02; S 5.78 |

Das Emissionsspektrum von **6a** ist in Fig. 10 gezeigt.

### IV. P∩N* = Ph₂PBntetrazol, 7a: Cu₂I₂(Ph₂PBntetrazol)₃, 8a

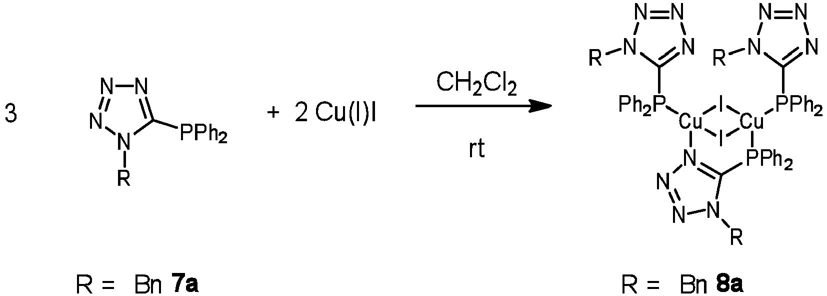

Bei der Verbindung **8a** handelt es sich um einen weißen, feinkristallinen Feststoff.

### Charakterisierung: Elementaranalyse:

| | |
|---|---|
| **8a** (R = Bn) | ber.: C 50.97; H 3.64; N 11.89 |
| | gef.: C 50.81; H 3.57; N 11.68 |

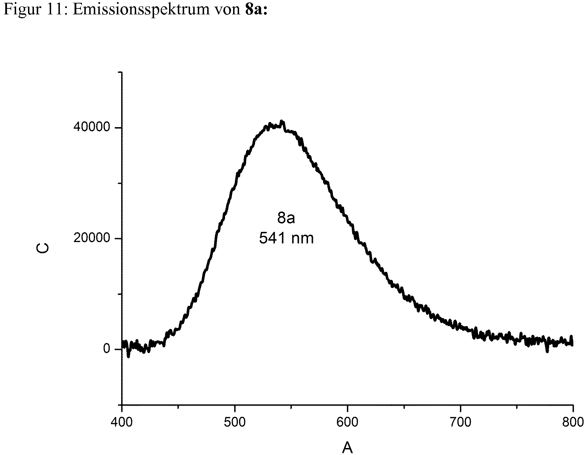

Das Emissionsspektrum von **8a** ist in Fig. 11 gezeigt.

Da bei den Verbindungen **2a** bis **8a** ausschließlich ein identischer zweizähniger Ligand im Verhältnis Cu:(N*∩E) = 2:3 (E = As, P) eingesetzt wird, erhält man in einem einzigen Schritt in hohen Ausbeuten extrem intensiv lumineszierende Komplexe der Formel A. Dadurch verringert sich der Syntheseaufwand.

Die erfindungsgemäßen Kupfer(I)komplexe zeichnen sich insbesondere durch eine Emission hin zum blauen oder in den blauen Emissionsbereich aus.

## Patentansprüche

1. Kupfer(I)komplex der Formel A 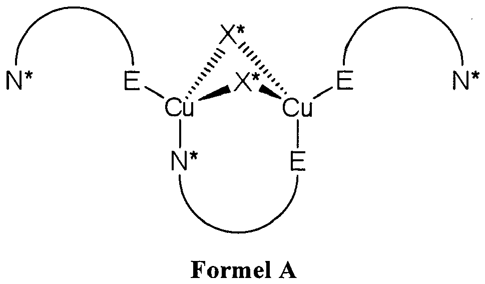 mit
X* = Cl, Br, I, CN, SCN, Alkinyl und/oder N₃ (unabhängig voneinander);
N*∩E = ein zweibindiger Ligand mit
E = Phosphanyl/Arsenyl-Rest der Form R₂E (mit R = Alkyl, Aryl, Alkoxyl, Phenoxyl, oder Amid);
N* = Imin-Funktion, die Bestandteil eines N-heteroaromatischen 5-Rings ist, der ausgewählt ist aus der Gruppe bestehend aus Pyrazol, Isoxazol, Isothiazol, Triazol, Oxadiazol, Thiadiazol, Tetrazol, Oxatriazol und Thiatriazol;
"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor- oder Arsenatom befindet,
wobei N*∩E optional mindestens einen Substituenten zur Erhöhung der Löslichkeit des Kupfer(I)komplexes in einem organischen Lösungsmittel aufweist.

2. Kupfer(I)komplex nach Anspruch 1, wobei N*∩E ausgewählt ist aus der Gruppe bestehend aus
| | |
|---|---|
| 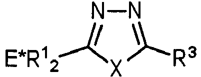 | X= NR²: 3E*R¹₂-4R²-5R³-4*H*-1,2,4-Triazol |
| | X= O: 2E*R¹₂-5R³-1,3,4-Oxadiazol |
| | X= S: 2E*R¹₂-5R³-1,3,4-Thiadiazol |
| | |
| 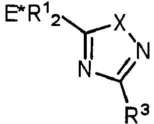 | X= NR²: 1R²-3R³-5E*R¹₂-1*H*-1,2,4-Triazol |
| | X= O: 3R³-5E*R¹₂-1,2,4-Oxadiazol |
| | X= S: 3R³-5E*R¹₂-1,2,4-Thiadiazol |
| | |
| 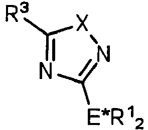 | X= NR²: 1R²-3E*R¹₂-5R³-1*H*-1,2,4-Triazol |
| | X= O: 3E*R¹₂-5R³-1,2,4-Oxadiazol |
| | X= S: 3E*R¹₂-5R3-1,2,4-Thiadiazol |
| | |
| 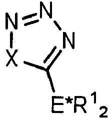 | X= NR²: 1R²-5E*R¹₂-1*H*-Tetrazol |
| | X= O: 5E*R¹₂-1,2,3,4-Oxatriazol |
| | X= S: 5E*R¹₂-1,2,3,4-Thiatriazol |
| | |
| 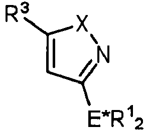 | X= NR²: 1R²-3E*R¹₂-5R³-1*H*-Pyrazol |
| | X= O: 3E*R¹₂-5R³-Isoxazol |
| | X= S: 3E*R¹₂-5R³-Isothiazol |
mit
X = O, S oder NR²;
E* = As oder P;
R1 = Alkyl, Aryl, Alkoxyl, Phenoxyl, oder Amid
R2-R3 = jeweils unabhängig voneinander Wasserstoff, Halogen oder Substituenten, die über Sauerstoff- (-OR), Stickstoff- (-NR₂) oder Siliziumatome (-SiR₃) gebunden sind sowie Alkyl-(auch verzweigt oder zyklisch), Aryl-, Heteroaryl-, Alkenyl-, Alkinyl-Gruppen oder substituierte Alkyl- (auch verzweigt oder zyklisch), Aryl-, Heteroaryl- und Alkenyl-Gruppen mit Substituenten wie Halogene oder Deuterium, Alkylgruppen (auch verzweigt oder zyklisch), und weitere Donor- und Akzeptor-Gruppen, wie beispielsweise Amine, Carboxylate und deren Ester, und CF₃-Gruppen, wobei R2-R3 optional zu annelierten Ringsystemen führen.

3. Kupfer(I)komplex nach Anspruch 1 oder 2, wobei der Substituent zur Erhöhung der Löslichkeit ausgewählt ist aus der Gruppe bestehend aus:
- verzweigten oder unverzweigten oder zyklischen langkettigen Alkylketten einer Länge von C1 bis C30,
- verzweigten oder unverzweigten oder zyklischen langkettigen Alkoxyketten einer Länge von C1 bis C30,
verzweigten oder unverzweigten oder zyklischen langkettigen Perfluoralkylketten einer Länge von C1 bis C30, und
- kurzkettigen Polyethern mit einer Kettenlänge von 3-50 Wiederholungseinheiten.

4. Verfahren zur Herstellung eines Kupfer(I)komplexes nach Anspruch 1 bis 3,
aufweisend den folgenden Schritt:
Durchführen einer Reaktion von N*∩E mit Cu(I)X*,
wobei
X* = Cl, Br, I, CN, SCN, Alkinyl und/oder N₃ (unabhängig voneinander)
N*∩E = ein zweibindiger Ligand mit
E = Phosphanyl/Arsenyl-Rest der Form R₂E (mit R = Alkyl, Aryl, Alkoxyl, Phenoxyl, oder Amid);
N* = Imin-Funktion, die Bestandteil eines N-heteroaromatischen 5-Rings ist der ausgewählt ist aus der Gruppe bestehend aus Pyrazol, Isoxazol, Isothiazol, Triazol, Oxadiazol, Thiadiazol, Tetrazol, Oxatriazol und Thiatriazol;
"∩" = mindestens ein Kohlenstoffatom, das ebenfalls Bestandteil der aromatischen Gruppe ist, wobei sich das Kohlenstoffatom sowohl direkt benachbart zum Imin-Stickstoffatom als auch zum Phosphor- oder Arsenatom befindet.

5. Verfahren nach Anspruch 4, wobei die Reaktion in Dichlormethan, Acetonitril, Tetrahydrofuran, Dimethylsulfoxid oder Ethanol durchgeführt wird.

6. Verfahren nach Anspruch 4 oder 5, weiterhin aufweisend den Schritt der Zugabe von Diethylether, Pentan, Methyl-butylether, Hexan, Methanol, Ethanol und/oder Wasser zur Gewinnung des Kupfer(I)komplexes in Form eines Feststoffs.

7. Verfahren nach Anspruch 4 bis 6, weiterhin aufweisend den Schritt der Substitution mindestens eines Liganden N*∩E mit mindestens einem Substituenten, der ausgewählt sein kann aus der Gruppe bestehend aus:
- langkettigen, verzweigten oder unverzweigten oder zyklischen Alkylketten einer Länge von C1 bis C30,
- langkettigen, verzweigten oder unverzweigten oder zyklischen Alkoxyketten einer Länge von C1 bis C30,
- verzweigten oder unverzweigten oder zyklischen Perfluoralkylketten einer Länge von C1 bis C30, und
- kurzkettigen Polyethern.

8. Verwendung eines Kupfer(I)komplexes nach Anspruch 1 bis 3 als Emitter oder Absorber in einem optoelektronischen Bauelement, insbesondere wobei das optoelektronische Bauelement ausgewählt ist aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.

9. Verwendung nach Anspruch 8 bis 9, **dadurch gekennzeichnet, dass** die Konzentration des Kupfer(I)komplexes als Emitter in optischen Licht emittierenden Bauelementen, insbesondere in OLEDs, zwischen 1 % und 80 % beträgt.

10. Optoelektronisches Bauelement, aufweisend einen Kupfer(I)komplex nach Anspruch 1 bis 3, insbesondere ausgeformt als ein Bauelement ausgewählt aus der Gruppe bestehend aus organischem lichtemittierendem Bauelement, organischer Diode, organischer Solarzelle, organischem Transistor, organischer lichtemittierender Diode, Lichtemittierender elektrochemischer Zelle, organischem Feldeffekttransistor und organischem Laser.

11. Verfahren zur Herstellung eines optoelektronischen Bauelements, wobei ein Kupfer(I)komplex nach Anspruch 1 bis 3 verwendet wird.

12. Verfahren nach Anspruch 11, **gekennzeichnet durch** Aufbringen eines Kupfer(I)komplexes nach Anspruch 1 bis 3 auf einen Träger, wobei das Aufbringen nass-chemisch, mittels kolloidaler Suspension oder mittels Sublimation erfolgt.

13. Verwendung eines zweizähnigen Liganden der Formel B zur Herstellung eines Kupferkomplexes der Formel A, 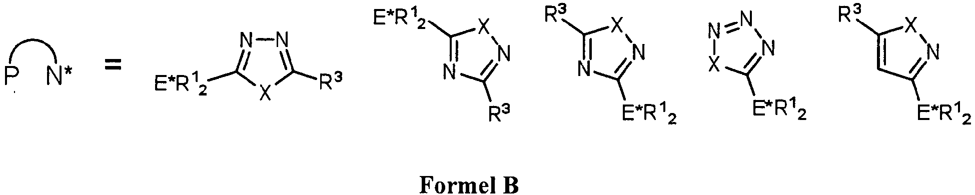 wobei die verwendeten Symbole den in den Ansprüchen 1 und 2 definierten entsprechen.

14. Verfahren zur Herstellung eines Liganden der Formel B 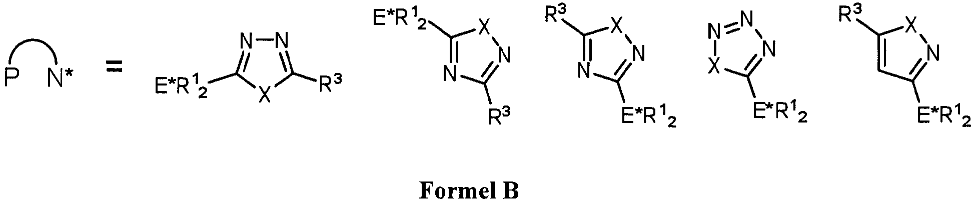 insbesondere gemäß dem folgenden Schema: 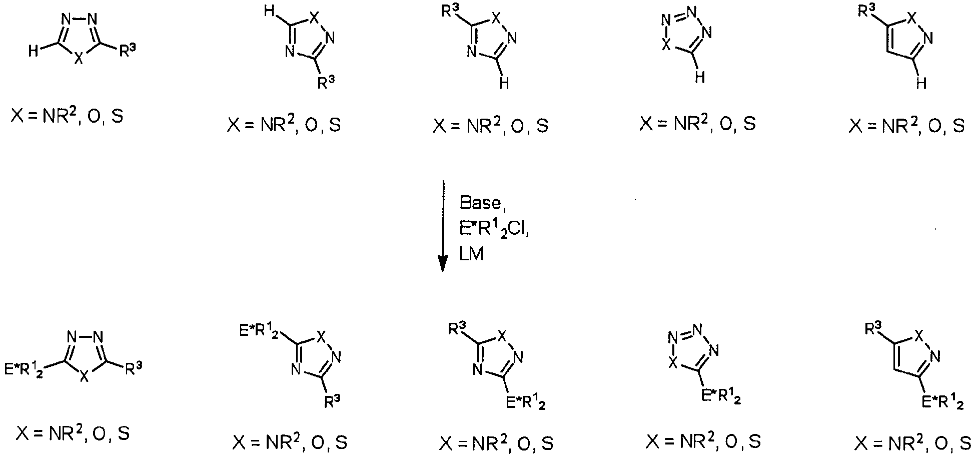 wobei die verwendeten Symbole den in den Ansprüchen 1 und 2 definierten entsprechen.

15. Verfahren zur Veränderung der Emissions- und/oder Absorptionseigenschaften eines elektronischen Bauelements, **gekennzeichnet durch**
Einbringen eines Kupfer(I)komplexes nach Anspruch 1 bis 3 in ein Matrixmaterial zur Leitung von Elektronen oder Löchern in einem optoelektronischen Bauelement.

16. Verwendung eines Kupfer(I)komplexes nach Anspruch 1 bis 3, insbesondere in einem optoelektronischen Bauelement, zur Umwandlung von UV-Strahlung oder von blauem Licht in sichtbares Licht, insbesondere in grünes, gelbes oder rotes Licht (Down-Konversion).

## Claims

1. A copper(I) complex of formula A 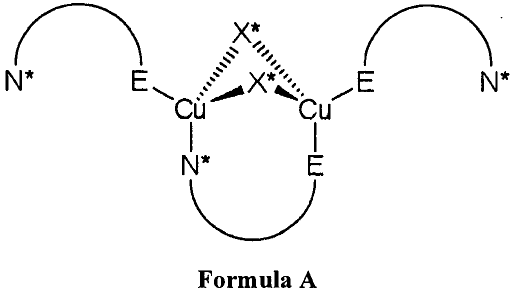 where
X = Cl, Br, I, CN, SCN, alkinyl, and/or N₃ (independently of each other);
N*∩E = a bidentate ligand wherein
E = phosphinyl/arsenyl group of the R₂E form (wherein R = alkyl, aryl, alkoxy, phenoxy or amide);
N* = imine function which is part of an N-heteroaromatic 5-membered ring that is selected from the group consisting of pyrazole, isoxazole, isothiazole, triazole, oxadiazole, thiadiazole, tetrazole, oxatriazole and thiatriazole;
"∩" = at least one carbon atom which is likewise part of the aromatic group, wherein the carbon atom is directly adjacent both to the imine nitrogen atom and to the phosphorus or arsenic atom,
wherein N*∩E optionally comprises at least one substituent for increasing the solubility of the copper(I) complex in an organic solvent.

2. The copper(I) complex of claim 1, wherein N*∩E is selected from the group consisting of
| | |
|---|---|
| 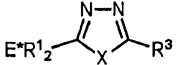 | X= NR²: 3E*R¹₂-4R²-5R³-4*H*-1,2,4-triazole |
| | X= O: 2E*R¹₂-5R³-1,3,4-oxadiazole |
| | X= S: 2E*R¹₂-5R³-1,3,4-thiadiazole |
| | |
| 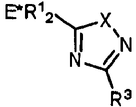 | X= NR²: 1R²-3R³-5E*R¹₂-1*H*-1,2,4-triazole |
| | X= O: 3R³-5E*R¹₂-1,2,4-oxadiazole |
| | X= S: 3R³-5E*R¹₂-1,2,4-thiadiazole |
| | |
| 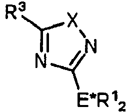 | X= NR²: 1R²-3E*R¹₂-5R³-1*H*-1,2,4-triazole |
| | X= O: 3E*R¹₂-5R³-1,2,4-oxadiazole |
| | X= S: 3E*R¹₂-5R³-1,2,4-thiadiazole |
| | |
| 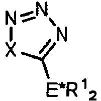 | X= NR²: 1R²-5E8R¹₂-1*H*-tétrazole |
| | X= O: 5E*R¹₂-1,2,3,4-oxatriazole |
| | X= S: 5E*R¹₂-1,2,3,4-thiatriazole |
| | |
| 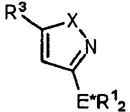 | X= NR²: 1R²-3E*R¹₂-5R³-1*H*-pyrazole |
| | X= O: 3E*R¹₂-5R³-isoxazole |
| | X= S: 3E*R¹₂-5R³-isothiazole |
where
X = O, S or NR²;
E* = As or P;
R1 = alkyl, aryl, alkoxy, phenoxy, or amide;
R2-R3 = each independently hydrogen, halogen or substituents bonded via oxygen (-OR), nitrogen (-NR₂), or silicium atoms (-SiR₃), as well as alkyl (also branched or cyclic), aryl, heteroaryl, alkenyl, alkynyl groups or substituted alkyl (also branched or cyclic), aryl, heteroaryl, and alkenyl groups with substituents like halogenes of deuterium, alkyl groups (also branched or cyclic), and further donor and acceptor groups, such as amines, carboxylates and their esters, and CF₃ groups,
wherein the R2-R3 groups optionally lead to fused ring systems.

3. The copper(I) complex of claim 1 or 2, wherein the substituent for increasing the solubility is selected from the group consisting of:
- branched or unbranched or cyclic long alkyl chains of length C1 to C30,
- branched or unbranched or cyclic long alkoxy chains of length C1 to C30,
- branched or unbranched or cyclic long perfluoroalkyl chains of length C1 to C30, and
- short-chain polyethers with a chain length of 3-50 repeat units.

4. A process for preparing a copper(I) complex of claims 1 to 3,
comprising the following step:
performance of a reaction of N*∩E with Cu(I)X,
where
X = Cl, Br, I, CN, SCN, alkinyl, and/or N₃ (independently of each other);
N*∩E = a bidentate ligand wherein
E = phosphinyl/arsenyl radical of the form R₂E (wherein R = alkyl, aryl, alkoxyl, phenoxy or amide);
N* = imine function which is part of an N-heteroaromatic 5-membered ring that is selected from the group consisting of pyrazole, isoxazole, isothiazole, triazole, oxadiazole, thiadiazole, tetrazole, oxatriazole and thiatriazole;
"∩" = at least one carbon atom which is likewise part of the aromatic group, wherein the carbon atom is directly adjacent both to the imine nitrogen atom and to the phosphorus or arsenic atom.

5. The process of claim 4, wherein the reaction is performed in dichloromethane, acetonitrile, tetrahydrofuran, dimethyl sulfoxide, or ethanol.

6. The process of claim 4 or 5, further comprising the step of addition of diethyl ether, pentane, methyl-butylether, hexane, methanol, ethanol and/or water to obtain the copper(I) complex in the form of a solid.

7. The process of claims 4 to 6, further comprising the step of substitution of at least one ligand N*∩E with at least one substituent which may be selected from the group consisting of:
- long-chain, branched or unbranched or cyclic alkyl chains of length C1 to C30,
- long-chain, branched or unbranched or cyclic alkoxy chains of length C1 to C30,
- branched or unbranched or cyclic perfluoroalkyl chains of length C1 to C30, and
- short-chain polyethers.

8. Use of a copper(I) complex of claims 1 to 3 as an emitter or an absorber in an optoelectronic device, in particular wherein the optoelectronic device is selected from the group consisting of:
- organic light-emitting diodes (OLEDs),
- light-emitting electrochemical cells,
- OLED sensors, especially in gas and vapor sensors without hermetic shielding to the outside,
- organic solar cells,
- organic field-effect transistors,
- organic lasers, and
- down-conversion elements.

9. The use of claim 8, **characterized in that** the concentration of the copper(I) complex as an emitter in optical light-emitting devices, especially in OLEDs, is between 1 % and 80 %.

10. An optoelectronic device comprising a copper(I) complex of claims 1 to 3, in particular in the form of a device selected from the group consisting of organic light-emitting devices, organic diode, organic solar cell, organic transistor, organic light-emitting diode, light-emitting electrochemical cell, organic field-effect transistor and organic laser.

11. A process for producing an optoelectronic device, wherein a copper(I) complex of claims 1 to 3 is used.

12. The process of claim 11, **characterized by** the application of a copper(I) complex of claims 1 to 3 onto a carrier, wherein the application is effected preferably by wet-chemical means, by means of colloidal suspension or by means of sublimation.

13. Use of a bidentate ligand of formula B for generating a copper complex of formula A, 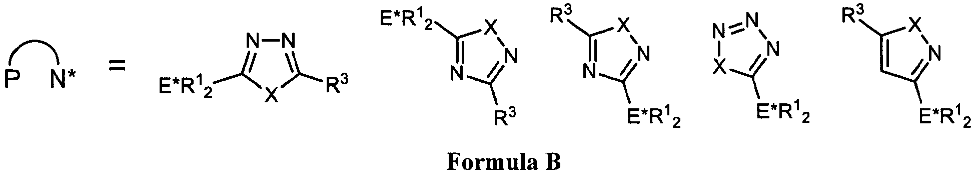 wherein the symbols used are defined in claims 1 and 2.

14. A process for generating a ligend of formula B 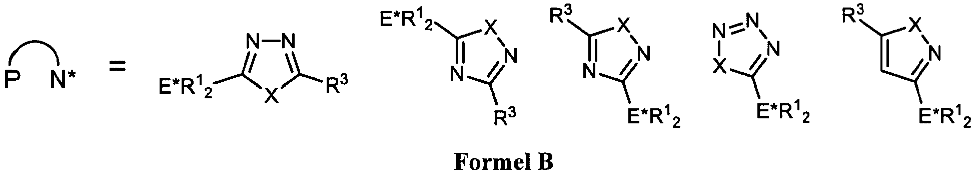 in particular according to the following scheme: 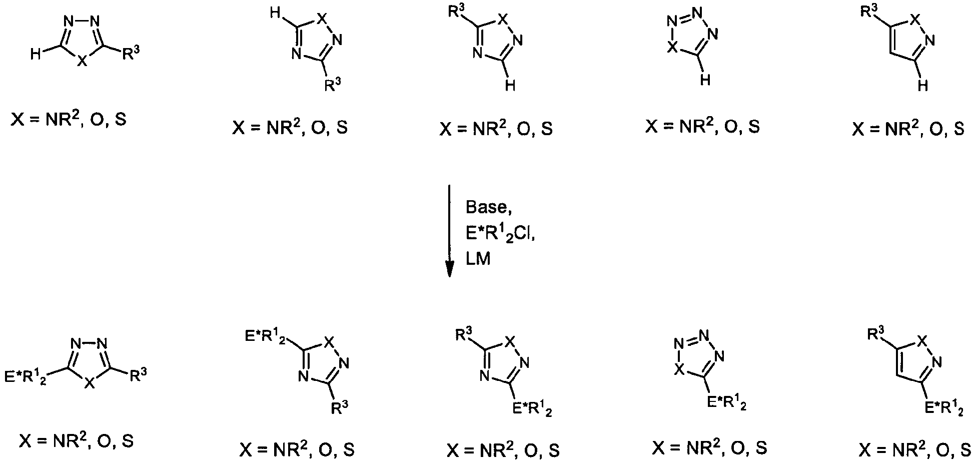 wherein the symbols used are defined in claims 1 and 2.

15. A process for altering the emission and/or absorption properties of an electronic device, **characterized by**
introduction of a copper(I) complex of claims 1 to 3 into a matrix material for conduction of electrons or holes in an optoelectronic device.

16. The use of a copper(I) complex of claims 1 to 3, especially in an optoelectronic device, for conversion of UV radiation or of blue light to visible light, especially to green, yellow or red light (down-conversion).

## Revendications

1. Complexe de cuivre(I) de formule A 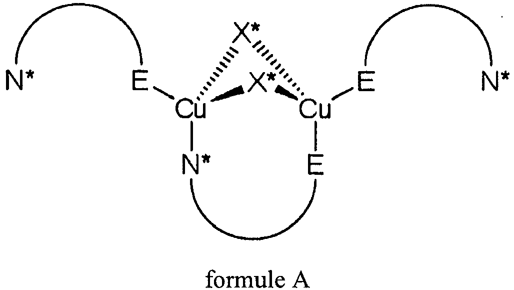 où
X* = Cl, Br, I, CN, SCN, alcynyle et/ou N₃ (chaque fois indépendamment) ;
N*∩E = un ligand à deux liaisons où
E = un radical phosphanyle/arsényle de formule R₂E (où R = alkyle, aryle, alcoxy, phénoxy ou amido) ;
N* = une fonction imine qui fait partie d'un cycle pentagonal N-hétéroaromatique qui est choisi dans le groupe constitué par pyrazole, isoxazole, isothiazole, triazole, oxadiazole, thiadiazole, tétrazole, oxatriazole et thiatriazole ;
« ∩ » = au moins un atome de carbone, qui fait également partie du groupe aromatique, l'atome de carbone se trouvant directement adjacent aussi bien à l'atome d'azote en fonction imine qu'à l'atome de phosphore ou d'arsenic,
N*∩E comportant en option au moins un substituant destiné à augmenter la solubilité du complexe de cuivre(I) dans un solvant organique.

2. Complexe de cuivre(I) selon la revendication 1, dans lequel N*∩E est choisi dans le groupe constitué par
| | |
|---|---|
| 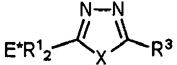 | X= NR²: 3E*R¹₂-4R²-5R³-4*H*-1,2,4-triazole |
| | X= O: 2E*R¹₂-5R³-1,3,4-oxadiazole |
| | X= S: 2E*R¹₂-5R³-1,3,4-thiadiazole |
| | |
| 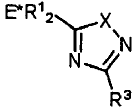 | X= NR²: 1R²-3R³-5E*R¹₂-1*H*-1,2,4-triazole |
| | X= O: 3R³-5E*R¹₂-1,2,4-oxadiazole |
| | X= S: 3R³-5E*R¹₂-1,2,4-thiadiazole |
| | |
| 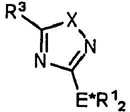 | X= NR²: 1R²-3E*R¹₂-5R³-1*H*-1,2,4-triazole |
| | X= O: 3E*R¹₂-5R³-1,2,4-oxadiazole |
| | X= S: 3E*R¹₂-5R³-1,2,4-thiadiazole |
| | |
| 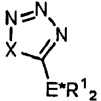 | X= NR²: 1R²-5E*R¹₂-1*H*-tétrazole |
| | X= O: 5E*R¹₂-1,2,3,4-oxatriazole |
| | X= S: 5E*R¹₂-1,2,3,4-thiatriazole |
| | |
| 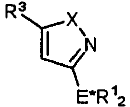 | X= NR²: 1R²-3E*R¹₂-5R³-1*H*-pyrazole |
| | X= O: 3E*R¹₂-5R³-isoxazole |
| | X= S: 3E*R¹₂-5R³-isothiazole |
où
X = O, S ou NR²
E* = As ou P
R1 = alkyle, aryle, alcoxy, phénoxy ou amido
R2-R3= chacun indépendamment les uns des autres un atome d'hydrogène ou d'halogène ou des substituants qui sont liés par des atomes d'oxygène (-OR), d'azote (-NR₂) ou de silicium (-SiR₃), ainsi que des groupes alkyle (également ramifiés ou cycliques), aryle, hétéroaryle, alcényle, alcynyle ou des groupes alkyle (également ramifiés ou cycliques), aryle, hétéroaryle et alcényle substitués portant des substituants tels que des halogènes ou le deutérium, des groupes alkyle (également ramifiés ou cycliques) et d'autres groupes donneurs ou accepteurs, comme par exemple des amines, des carboxylates et leurs esters, et des groupes CF₃,
les groupes R2-R3 conduisant en option à des systèmes cycliques condensés.

3. Complexe de cuivre(I) selon la revendication 1 ou 2, dans lequel le substituant destiné à augmenter la solubilité est choisi dans le groupe constitué par :
- des chaînes alkyle à longue chaîne ramifiées ou non ramifiées ou cycliques ayant une longueur de C1 à C30,
- des chaînes alcoxy à longue chaîne ramifiées ou non ramifiées ou cycliques ayant une longueur de C1 à C30,
- des chaînes perfluoroalkyle à longue chaîne ramifiées ou non ramifiées ou cycliques ayant une longueur de C1 à C30, et
- des polyéthers à courte chaîne ayant une longueur de chaîne de 3-50 motifs répétitifs.

4. Procédé pour la préparation d'un complexe de cuivre(I) selon l'une quelconque des revendications 1 à 3, comportant l'étape suivante :
exécution d'une réaction de N*∩E avec Cu(I)X*,
où
X* = Cl, Br, I , CN, SCN, alcynyle et/ou N₃ (chaque fois indépendamment)
N*∩E = un ligand à deux liaisons où
E = un radical phosphanyle/arsényle de forme R₂E (où R = alkyle, aryle, alcoxy, phénoxy ou amido) ;
N* = une fonction imine qui fait partie d'un cycle pentagonal N-hétéroaromatique qui est choisi dans le groupe constitué par pyrazole, isoxazole, isothiazole, triazole, oxadiazole, thiadiazole, tétrazole, oxatriazole et thiatriazole ;
« ∩ » = au moins un atome de carbone, qui fait également partie du groupe aromatique, l'atome de carbone se trouvant directement adjacent aussi bien à l'atome d'azote en fonction imine qu'à l'atome de phosphore ou d'arsenic.

5. Procédé selon la revendication 4, dans lequel la réaction est effectuée dans du dichlorométhane de l'acétonitrile, du tétrahydrofurane, du diméthylsulfoxyde ou de l'éthanol.

6. Procédé selon la revendication 4 ou 5, comportant en outre l'étape d'addition d'oxyde de diéthyle, de pentane d'éther méthylbutylique, d'hexane, de méthanol, d'éthanol et/ou d'eau pour l'obtention du complexe de cuivre(I) sous forme d'un solide.

7. Procédé selon l'une quelconque des revendications 4 à 6, comportant en outre l'étape de substitution d'au moins un ligand N*∩E par au moins un substituant qui est choisi dans le groupe constitué par :
- des chaînes alkyle à longue chaîne ramifiées ou non ramifiées ou cycliques ayant une longueur de C1 à C30,
- des chaînes alcoxy à longue chaîne ramifiées ou non ramifiées ou cycliques ayant une longueur de C1 à C30,
- des chaînes perfluoroalkyle ramifiées ou non ramifiées ou cycliques ayant une longueur de C1 à C30, et
- des polyéthers à courte chaîne.

8. Utilisation d'un complexe de cuivre(I) selon l'une quelconque des revendications 1 à 3, en tant qu'émetteur ou absorbeur dans un composant optoélectronique, en particulier dans laquelle le composant optoélectronique est choisi dans le groupe constitué par :
- des composants photoémetteurs organiques (OLED),
- des cellules électrochimiques photoémettrices,
- des capteurs OLED, en particulier dans des capteurs de gaz et de vapeur non hermétiquement isolés de l'extérieur,
- des cellules solaires organiques,
- des transistors à effet de champ organiques,
- des lasers organiques et
- des éléments de down-conversion.

9. Utilisation selon la revendication 8, **caractérisée en ce que** la concentration du complexe de cuivre(I) en tant qu'émetteur dans des composants photoémetteurs optiques, en particulier dans des OLED, est comprise entre 1 % et 80 %.

10. Composant optoélectronique, comportant un complexe de cuivre(I) selon l'une quelconque des revendications 1 à 3, en particulier conçu en tant qu'un composant choisi dans le groupe constitué par un composant photoémetteur organique, une diode organique, une cellule solaire organique, un transistor organique, une diode photoémettrice organique, une cellule électrochimique photoémettrice, un transistor à effet de champ organique et un laser organique.

11. Procédé pour la fabrication d'un composant optoélectronique, dans lequel on utilise un complexe de cuivre(I) selon l'une quelconque des revendications 1 à 3.

12. Procédé selon la revendication 11, **caractérisé par** l'application d'un complexe de cuivre(I) selon l'une quelconque des revendications 1 à 3 sur un support, où l'application s'effectue par voie chimique-humide, au moyen d'une suspension colloïdale ou par sublimation.

13. Utilisation d'un ligand bidenté de formule B pour la préparation d'un complexe de cuivre de formule A, 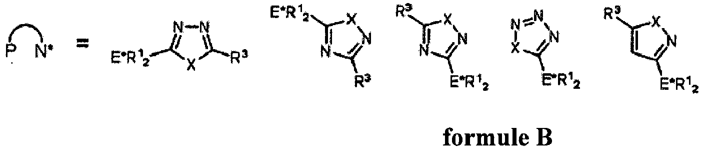 les symboles utilisés correspondant à ceux définis dans les revendications 1 et 2.

14. Procédé pour la préparation d'un ligand de formule B 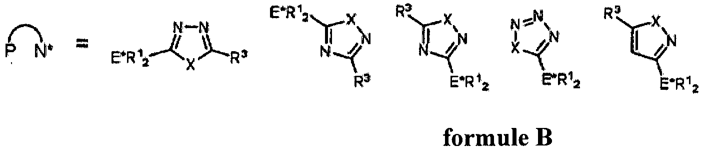 en particulier selon le schéma suivant : 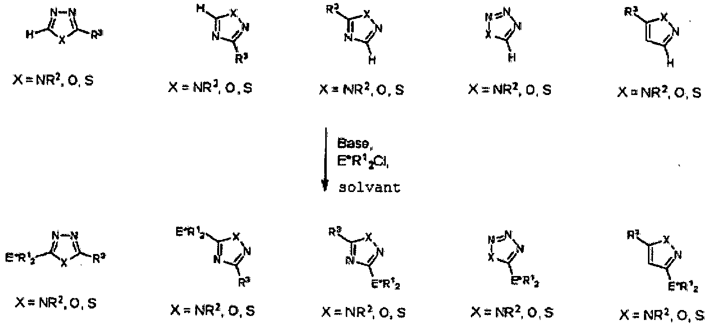 les symboles utilisés correspondant à ceux définis dans les revendications 1 et 2.

15. Procédé pour la modification des propriétés d'émission ou d'absorption d'un composant électronique, **caractérisé par**
l'introduction d'un complexe de cuivre(I) selon l'une quelconque des revendications 1 à 3 dans un matériau matrice pour la conduction d'électrons ou de trous dans un composant optoélectronique.

16. Utilisation d'un complexe de cuivre(I) selon l'une quelconque des revendications 1 à 3, en particulier dans un composant optoélectronique, pour la conversion d'un rayonnement UV ou de lumière bleue en lumière visible, en particulier en lumière verte, jaune ou rouge (down-conversion).
